(19) Europäisches Patentamt
European Patent Office
Office européen des brevets

(11) EP 2 422 401 B1

(12) **FASCICULE DE BREVET EUROPEEN**

(45) Date de publication et mention
de la délivrance du brevet:
**01.08.2018 Bulletin 2018/31**

(21) Numéro de dépôt: **10716324.8**

(22) Date de dépôt: **21.04.2010**

(51) Int Cl.:
***H01P 5/12*** *(2006.01)*    ***H03F 3/60*** *(2006.01)*

(86) Numéro de dépôt international:
**PCT/EP2010/055300**

(87) Numéro de publication internationale:
**WO 2010/122074 (28.10.2010 Gazette 2010/43)**

(54) **DISPOSITIF D'AMPLIFICATION DE PUISSANCE À ENCOMBREMENT RÉDUIT**

LEISTUNGSVERSTÄRKERANORDNUNG MIT VERRINGERTER MASSE

POWER AMPLIFIER DEVICE WITH REDUCED BULK

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **24.04.2009 FR 0902006**

(43) Date de publication de la demande:
**29.02.2012 Bulletin 2012/09**

(73) Titulaire: **THALES
92400 Courbevoie (FR)**

(72) Inventeurs:
• **FRAYSSE, Jean-Philippe
F-31200 Toulouse (FR)**
• **MAIGNAN, Michel
F-31860 Pins Justaret (FR)**

(74) Mandataire: **Esselin, Sophie et al
Marks & Clerk France
Conseils en Propriété Industrielle
Immeuble Visium
22 avenue Aristide Briand
94117 Arcueil Cedex (FR)**

(56) Documents cités:
**EP-A1- 0 032 332        WO-A1-2009/026704
FR-A1- 2 925 230        US-A- 4 092 616
US-A1- 2004 041 658    US-A1- 2005 057 321
US-A1- 2010 045 385**

• **DENOUAL J M ET AL: "16-Way Radial
Divider/Combiner for Solid State Power
Amplifiers in the K Band" MICROWAVE
CONFERENCE, 2008. EUMC 2008. 38TH
EUROPEAN, IEEE, PISCATAWAY, NJ, USA, 27
octobre 2008 (2008-10-27), pages 345-348,
XP031407166 ISBN: 978-2-87487-006-4**

## Description

La présente invention concerne un dispositif d'amplification de puissance à encombrement réduit. Elle s'applique au domaine des amplificateurs hyperfréquences à semi-conducteurs et plus particulièrement aux systèmes de combinaison de puissance et notamment aux antennes actives.

La diminution de la puissance de sortie des éléments semi-conducteurs avec l'augmentation de la fréquence de fonctionnement des dispositifs d'amplification conduit à devoir combiner plusieurs amplificateurs semi-conducteurs élémentaires pour atteindre les puissances de sortie requises par certaines applications dans le domaine des hyperfréquences. En particulier, pour une antenne active en bande Ku et pour obtenir un niveau de puissance suffisant, il est souvent nécessaire de combiner plusieurs modules amplificateurs dans une maille d'antenne dont les dimensions sont de l'ordre de quelques centimètres.

Les systèmes de combinaison de puissance actuels basés sur des architectures à lignes ou guides d'ondes arborescents ou radiaux ne permettent pas de combiner efficacement des amplificateurs élémentaires dans un environnement confiné avec une interface de sortie en guide d'ondes rectangulaire apte à coopérer avec les dispositifs en aval.

Dans une structure arborescente combinant plusieurs amplificateurs, les amplificateurs sont disposés parallèlement les uns aux autres et alignés selon un même axe. Les guides d'ondes d'entrée et de sortie des amplificateurs, le diviseur et le combineur sont également alignés selon ce même axe. En bande Ku et en technologie guide rectangulaire, la largeur d'un tel dispositif d'amplification est principalement contrainte par la taille importante des guides rectangulaires du combineur. Ainsi, en ne prenant en compte que la valeur de la dimension intérieure selon une section transversale d'un guide rectangulaire normalisé en bande Ku, égale à 1,9 cm, la largeur d'un dispositif d'amplification comportant par exemple huit amplificateurs est au minimum huit fois plus grande, soit supérieure à 15cm. Cette largeur étant bien supérieure aux contraintes dimensionnelles d'une application concernant une antenne active en bande Ku, cette technique n'est donc pas adaptée à ce type d'application. Pour des applications à fréquences plus hautes, la taille des guides rectangulaires diminue et la largeur du dispositif d'amplification n'est plus imposée par le combineur mais par la largeur des amplificateurs élémentaires, des capacités de découplage et des accès de polarisation de ces amplificateurs. Cette largeur est donc également trop importante par rapport à la maille d'une antenne active.

La technique de combinaison spatiale telle que développée dans le brevet US5736908 comprend plusieurs modules amplificateurs disposés sur des plateaux, se superposant dans un guide d'ondes rectangulaire. Le signal d'entrée généré par une seule source se répartit sur les modules amplificateurs grâce à la distribution spatiale de l'énergie du signal et se recombine en sortie une fois amplifié suivant le même principe. Cette solution permet d'effectuer en une seule étape d'une part la combinaison des signaux et d'autre part les transitions entre les lignes en technologie planaire et l'interface de sortie en guide d'ondes rectangulaire. Grâce à ces caractéristiques, elle permet de minimiser les pertes de combinaison et l'encombrement de la structure. Toutefois, cette technique de combinaison, telle que décrite dans l'état de la technique, présente des inconvénients et des limitations.

En effet, le nombre de plateaux empilés dans un guide d'ondes rectangulaire et le nombre d'amplificateurs associés sur un même plateau diminuent avec la réduction de la taille des guides d'ondes rectangulaires imposée par l'augmentation de la fréquence de fonctionnement.

Pour des applications à fréquences hautes telles que par exemple en bande Ka, la taille des guides rectangulaires normalisée est beaucoup plus faible que la taille des modules amplificateurs, ce qui nécessite d'avoir de longues lignes de transmission pour relier les modules amplificateurs aux transitions du diviseur spatial excité par une seule source et aux transitions du combineur spatial. Ces lignes de transmissions sont très pénalisantes en termes de pertes et l'efficacité de la division et de la combinaison est dégradée. Une structure à quatre plateaux serait la mieux adaptée en terme de compacité pour combiner huit amplificateurs élémentaires dans le cas d'une antenne active en bande Ku. Toutefois, dans cette configuration, ce type d'architecture présente un management thermique défavorable pour les plateaux localisés au centre de la structure et un manque d'isolation entre les amplificateurs combinés pouvant entraîner dans certain cas une instabilité du dispositif d'amplification.

Le document WO 20060967771 décrit une autre technique de combinaison spatiale dans laquelle les axes des amplificateurs sont disposés selon une direction perpendiculaire aux guides d'ondes d'entrée et de sortie, cependant pour des applications à fréquences hautes, en bande Ka par exemple, les longues lignes de transmission d'entrée sont pénalisantes en terme de pertes de division.

D'autres types de dispositifs d'amplification sont décrits dans les documents EP 0032332 et WO 2009/026704.

Le but de l'invention est de réaliser un dispositif d'amplification à encombrement réduit ne comportant pas les inconvénients des dispositifs existants et permettant de combiner notamment un grand nombre d'amplificateurs dans la maille d'une antenne active en bande Ku de dimensions de l'ordre de quelques centimètres avec une forte efficacité de combinaison et peu de pertes de division.

Pour cela, l'invention concerne un dispositif d'amplification à encombrement réduit comportant au moins un plateau parallèle à un plan XY et au moins deux modules amplificateurs montés sur le plateau, chaque module amplificateur comportant un élément amplificateur, un guide d'ondes de connexion d'entrée et un guide d'ondes de connexion de sortie orientés selon une même direction X correspondant à une direction de propagation longitudinale, l'élément amplificateur ayant un axe d'entrée et de sortie orienté selon une direction Y perpendiculaire à la direction de propagation X, caractérisé en ce que les guides de connexion d'entrée des deux modules amplificateurs sont distincts, ont des longueurs différentes et sont montés parallèlement l'un par rapport à l'autre, les guides de connexion de sortie des deux modules amplificateurs sont distincts, ont des longueurs différentes et sont montés parallèlement l'un par rapport à l'autre, et en ce que la somme des longueurs des guides d'entrée et de sortie d'un même module amplificateur est identique pour chaque module amplificateur, les modules amplificateurs étant montés parallèlement sur au moins une rangée, les guides d'ondes d'entrée des éléments amplificateurs de la rangée étant précédés par un diviseur de puissance et les guides d'ondes de sortie des éléments amplificateurs de la rangée étant reliés à un combineur de puissance de sortie, de sorte que les signaux transmis par les guide d'ondes de connexion de sortie (13a, 13b) au combineur de puissance (16) sont en phase.

Avantageusement, les guides d'ondes d'entrée, respectivement les guides d'ondes de sortie, des éléments amplificateurs de la rangée étant accolés les uns aux autres et les éléments amplificateurs de la rangée étant décalés l'un par rapport à l'autre selon les deux directions perpendiculaires X et Y.

Avantageusement, le diviseur d'entrée et/ou le combineur de sortie peuvent comporter un septum résistif prolongeant des parois séparant les guides d'ondes de connexion.

Avantageusement, le dispositif d'amplification comporte en outre une transition d'entrée disposée entre chaque guide de connexion d'entrée et l'élément amplificateur correspondant et une transition de sortie disposée entre chaque guide de connexion de sortie et l'élément amplificateur correspondant.

Selon un mode de réalisation, le dispositif d'amplification comporte deux rangées d'amplification distinctes, chaque rangée d'amplification comportant le même nombre de modules amplificateurs, les modules amplificateurs de la première rangée étant montés symétriquement par rapport aux modules amplificateurs de la deuxième rangée de part et d'autre d'un axe de symétrie parallèle à la direction de propagation.

Avantageusement, chaque module amplificateur de la première rangée comporte un élément amplificateur ayant un axe d'entrée et de sortie orienté suivant la direction Y et aligné respectivement avec un axe d'entrée et de sortie d'un élément amplificateur d'un module amplificateur de la deuxième rangée.

Avantageusement, les guides d'ondes de connexion de sortie des éléments amplificateurs de tous les modules amplificateurs des deux rangées sont distincts, accolés les uns aux autres et reliés à un combineur de puissance de sortie, commun à tous les guides d'ondes de connexion de sortie.

Avantageusement, le dispositif d'amplification comporte en outre un premier diviseur de puissance d'entrée ayant deux sorties reliées respectivement aux deux rangées d'amplification à travers deux transitions et chaque rangée d'amplification comporte un deuxième diviseur de puissance ayant des sorties reliées respectivement à chaque guide d'ondes de connexion d'entrée des modules amplificateurs correspondants. Le premier diviseur de puissance d'entrée peut comporter une entrée de type micro-ruban.

Selon un mode de réalisation, le dispositif d'amplification comporte au moins deux modules amplificateurs superposés l'un au-dessus de l'autre, les deux modules amplificateurs étant disposés sur au moins deux plateaux distincts, superposés l'un au-dessus de l'autre et comportant un même nombre de modules amplificateurs et les deux modules amplificateurs superposés ont un guide d'entrée et un guide de sortie en commun.

Avantageusement, les éléments de transitions sont choisis parmi des lignes à ailettes, ou des plongeurs comportant une ligne de métallisation placée sur un substrat, ou des plongeurs mécaniques utilisant une perle de verre.

Préférentiellement, les guides d'ondes de connexion d'entrée et de sortie sont des guides d'ondes métalliques à section rectangulaire. En outre, le diviseur de puissance et le combineur de puissance peuvent également être des guides d'ondes métalliques à section rectangulaire.

Préférentiellement, chaque guide d'onde de connexion d'entrée est équipé d'un élément de réglage de phase.

Avantageusement, le dispositif d'amplification comporte un dispositif d'alimentation opto-électronique connecté en entrée du dispositif d'amplification par l'intermédiaire d'une fibre optique et d'une transition.

D'autres particularités et avantages de l'invention apparaîtront clairement dans la suite de la description donnée à titre d'exemple purement illustratif et non limitatif, en référence aux dessins schématiques annexés qui représentent :

- figure 1 : un schéma d'un premier exemple de module amplificateur, selon l'invention ;
- figure 2 : un schéma d'un premier exemple de dispositif d'amplification comprenant deux modules amplificateurs combinés sur un plateau et sur une rangée, selon l'invention ;
- figures 3a à 3e: deux schémas et trois vues en coupe longitudinale et transversales suivant le plan de coupe I-I et le plan de coupe J-J d'un deuxième exemple de dispositif d'amplification comprenant quatre modules amplificateurs combinés sur un plateau et sur une rangée, selon l'invention ;

- figures 4a et 4b : deux vues en coupe transversale suivant le plan de coupe I-I et le plan de coupe J-J d'un dispositif d'amplification comportant deux rangées de modules amplificateurs disposés sur deux plateaux superposés, selon une variante de réalisation de l'invention ;
- figures 5a et 5b : deux schémas d'un troisième et d'un quatrième exemple de dispositifs d'amplification comprenant plusieurs modules amplificateurs combinés sur deux rangées d'un même plateau, selon une variante de réalisation de l'invention ;
- figure 6 : une vue en coupe longitudinale d'une variante de réalisation de l'invention comportant une rangée de deux modules amplificateurs combinés sur un seul plateau, selon l'invention ;
- figures 7a, 7b et 7c: une vue schématique de détail d'un exemple de septum et deux vues schématiques de détail de deux exemples de combineurs de type septum, respectivement à un étage et à deux étages, selon l'invention ;
- figures 8a à 8d: quatre vues schématiques en coupe d'exemples de transitions, selon l'invention ;
- Figure 9: un exemple schématique d'un dispositif d'alimentation du dispositif d'amplification, selon l'invention.

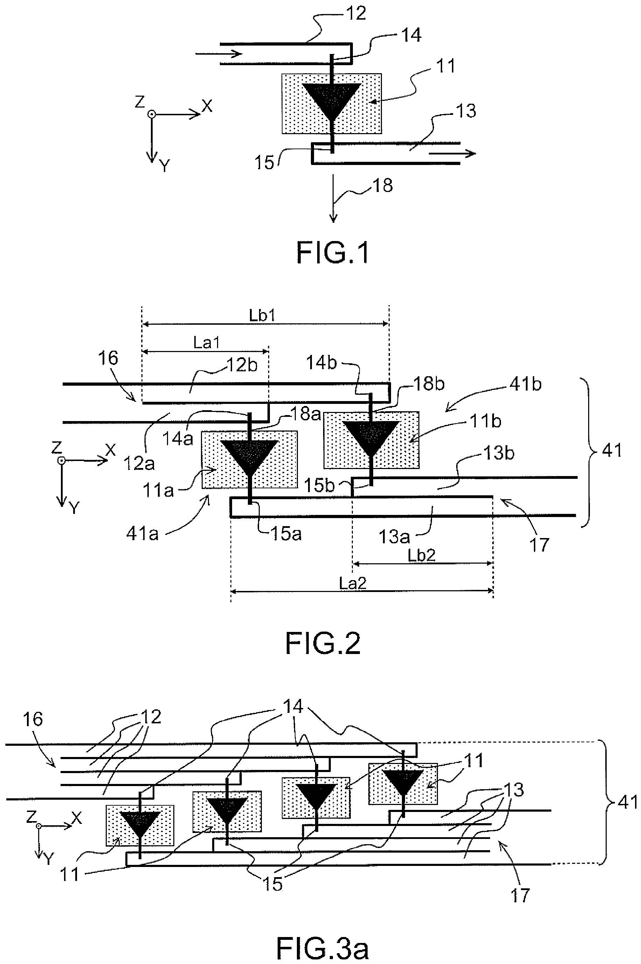

Le module amplificateur représenté sur la figure 1 comporte un élément amplificateur 11, un guide d'ondes de connexion d'entrée 12, un guide d'ondes de connexion de sortie 13, une transition d'entrée 14 assurant la transition entre le guide d'entrée et le module amplificateur, une transition de sortie 15 assurant la transition entre le guide de sortie et le module amplificateur. Les guides d'ondes d'entrée et de sortie 12, 13 sont orientés selon une même direction X correspondant à une direction longitudinale de propagation et ont une section transversale qui peut être par exemple rectangulaire. L'élément amplificateur 11 a un axe d'entrée et de sortie 18 orienté suivant une direction Y perpendiculaire à la direction de propagation longitudinale. Les transitions d'entrée 14 et de sortie 15 sont perpendiculaires à la direction de propagation longitudinale X et assurent l'adaptation électrique entre l'élément amplificateur 11 et les guides d'ondes rectangulaires d'entrée 12 et de sortie 13.

La figure 2 représente un schéma d'un premier exemple de dispositif d'amplification selon l'invention, comprenant deux modules amplificateurs constituant deux voies amplificatrices. Les deux modules amplificateurs 41a, 41b sont montés parallèlement sur un même plateau XY et sur une même rangée 41 de façon que les deux guides d'ondes d'entrée 12a, 12b, respectivement les deux guides d'ondes de sortie 13a, 13b, des deux éléments amplificateurs 11a, 11b soient accolés les uns aux autres et que les deux éléments amplificateurs 11a, 11b, ne soient pas alignés sur un même axe mais décalés l'un par rapport à l'autre selon les deux directions perpendiculaires X et Y. Les éléments amplificateurs 11a, 11b ont des guides d'ondes d'entrée distincts et des guides d'ondes de sortie distincts auxquels ils sont respectivement connectés par l'intermédiaire des transitions d'entrée 14a, 14b et des transitions de sorties 15a, 15b, et respectivement un axe d'entrée et de sortie 18a, 18b orienté suivant une direction Y perpendiculaire à la direction de propagation X. Les deux guides d'ondes d'entrée 12a, 12b, respectivement les deux guides d'ondes de sortie 13a, 13b, des deux éléments amplificateurs 11a, 11b ont des longueurs La1, La2, respectivement Lb1, Lb2, différentes selon l'axe longitudinal de propagation X mais la somme des longueurs des guides d'ondes d'entrée et de sortie d'un même module amplificateur est identique pour tous les modules amplificateurs :

$$La1 + La2 = Lb1 + Lb2$$

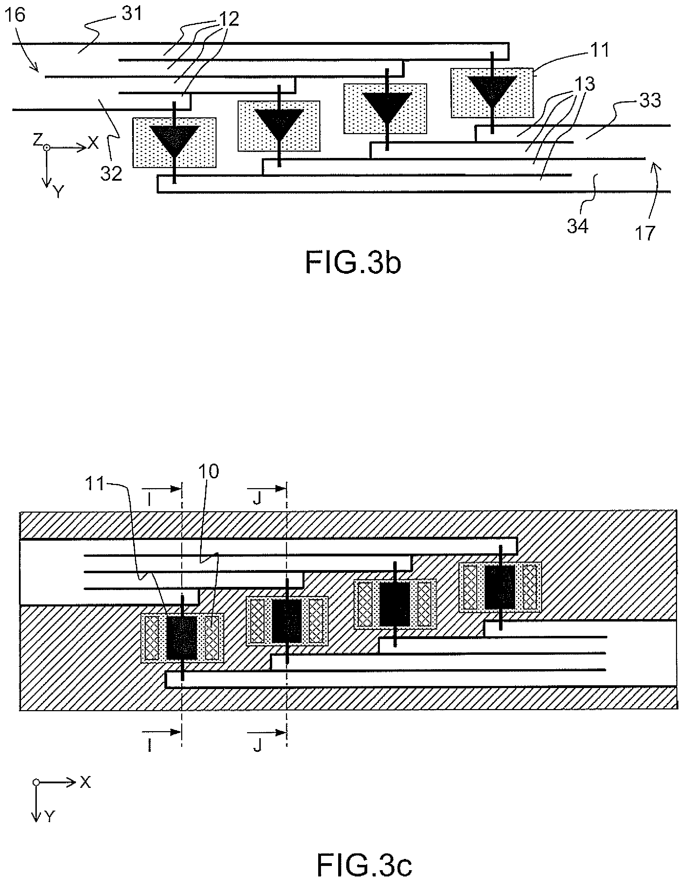

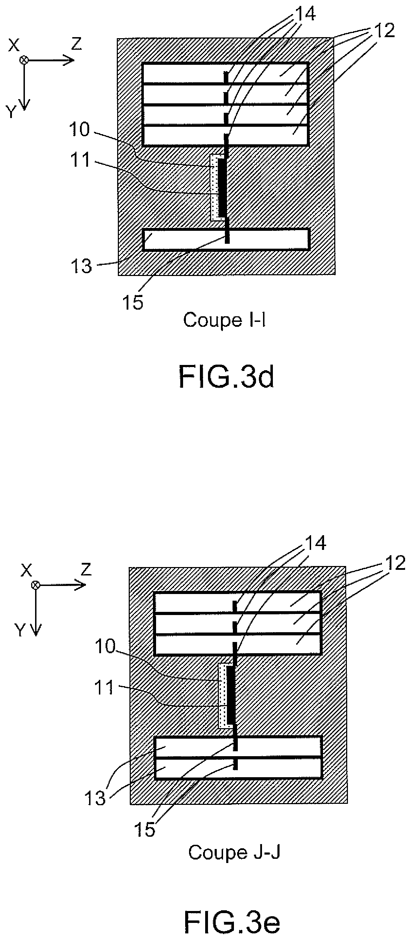

Les deux guides d'ondes d'entrée 12a, 12b des deux éléments amplificateurs 11a, 11b sont précédés par un diviseur de puissance 16 permettant de diviser un signal hyperfréquence, par exemple dans la bande 10,5 GHz et 14 GHz, d'entrée en deux composantes se propageant dans les deux guides d'ondes de connexion d'entrée 12a, 12b et les deux guides d'ondes de sortie 13a, 13b des deux éléments amplificateurs 11a, 11b sont reliés à un combineur de puissance 17 permettant de recombiner les signaux hyperfréquences de sortie amplifiés par chaque élément amplificateur. Chaque élément amplificateur comporte un circuit de polarisation avec des capacités de découplage 10 comme représenté par exemple sur la figure 3c montrant quatre modules amplificateurs combinés sur une même rangée et constituant quatre voies amplificatrices.

Le diviseur de puissance 16 est réalisé en technologie guide d'ondes métallique et est constitué d'une entrée et de deux sorties en guide rectangulaire. Le diviseur peut être de type « septum divider » (terminologie anglo-saxonne). Dans ce type de diviseur, les deux guides de sortie sont généralement séparés à l'endroit de la division par une fine paroi constituant le « septum » (terme latin) qui peut être métallique ou résistif. Le combineur de puissance 17 est également réalisé en technologie guide d'ondes métallique est constitué de deux entrées et d'une sortie en guide rectangulaire et peut être de type « septum combiner ». Le diviseur 16 et le combineur 17 de types «septum divider» et «septum combiner» permettent de diviser et combiner les signaux hyperfréquences dans un encombrement réduit avec de faibles pertes. La somme des longueurs des guides d'ondes d'entrée 12a, 12b et de sortie 13a, 13b étant identique pour les deux modules amplificateurs 41a, 41b, les signaux à l'entrée du combineur sont en phase et la recombinaison des signaux amplifiés par les deux voies amplificatrices est réalisée en phase sans l'ajout d'un déphaseur. Le nombre de modules amplificateurs combinés de cette façon n'est pas limité à deux.

Comme représenté sur les différents schémas et plans de coupe des figures 3a à 3e montrant quatre modules amplificateurs combinés sur une même rangée et constituant quatre voies amplificatrices, il est possible de combiner un grand nombre de modules amplificateurs comportant des éléments amplificateurs décalés les uns par rapport aux autres selon les deux directions perpendiculaires X et Y, les guides d'ondes d'entrée, respectivement de sortie, des différents éléments amplificateurs étant accolés les uns aux autres et ayant des longueurs d'entrée et de sortie différentes et telles que la somme des longueurs des guides d'ondes d'entrée et de sortie d'un même module amplificateur est identique pour tous les modules amplificateurs. Ainsi, sur chaque voie d'amplification, le chemin électrique correspondant au guide d'entrée est différent du chemin électrique correspondant au guide de sortie mais pour toutes les voies, la somme des chemins électriques correspondant aux guides d'entrée et de sortie d'une même voie est identique, ce qui permet, en sortie, d'avoir une phase identique pour tous les signaux et de recombiner tous les signaux hyperfréquences en phase sans l'ajout d'un déphaseur.

Le mode de réalisation représenté sur la figure 3b montre un dispositif d'amplification comportant un diviseur d'entrée 16 et un combineur de sortie 17 à deux étages. Dans ce mode de réalisation, le signal d'entrée est divisé en deux étapes. Dans une première étape le signal est réparti entre deux guides d'ondes rectangulaires intermédiaires 31, 32, puis dans une deuxième étape, chacun des signaux se propageant dans les deux guides d'ondes rectangulaires intermédiaires 31, 32 sont de nouveau divisés en deux et répartis dans les quatre guides d'ondes de connexion d'entrée 12 des quatre éléments amplificateurs 11. Au niveau du combineur de sortie 17, les quatre signaux amplifiés par les quatre voies d'amplification sont combinés deux à deux en phase en deux étapes. Dans une première étape, les quatre signaux de sortie se propageant dans les quatre guides de connexion de sortie 13 des amplificateurs 11 sont recombinés en phase dans deux guides d'ondes rectangulaires intermédiaires de sortie 33, 34, puis dans une deuxième étape, chacun des signaux se propageant dans les deux guides d'ondes rectangulaires intermédiaires 33, 34 sont de nouveau combinés en phase dans le guide d'ondes de sortie du combineur 17.

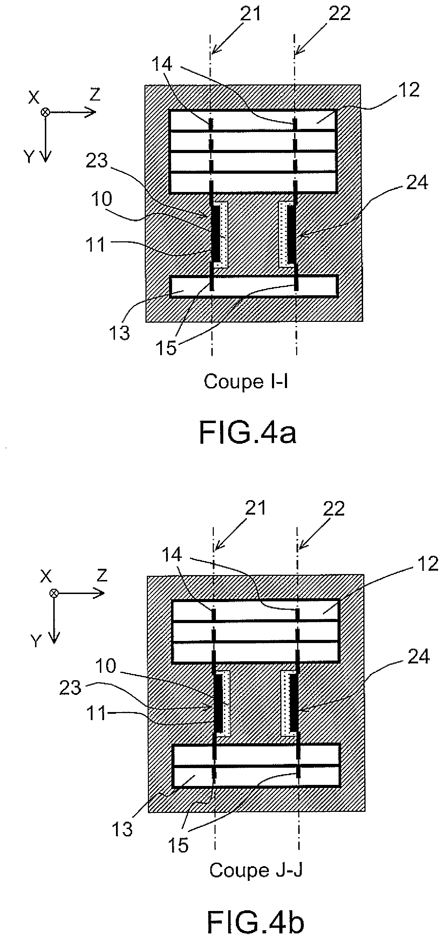

Selon une première variante de réalisation de l'invention, les modules amplificateurs de la figure 3a peuvent être regroupés par paires, les modules de chaque paire étant disposés sur deux plateaux 21, 22 distincts et superposés comme le montre les vues en coupes transversales selon le plan de coupe I-I et le plan de coupe J-J des figures 4a et 4b. Dans ce cas, chaque paire comporte deux modules amplificateurs superposés 23, 24 qui ont un guide d'ondes de connexion d'entrée et un guide d'ondes de connexion de sortie en commun. Un même guide d'ondes de connexion d'entrée excite donc deux amplificateurs élémentaires par l'intermédiaire de deux transitions d'entrée. En sortie, les deux amplificateurs élémentaires sont respectivement connectés au même guide de connexion de sortie par l'intermédiaire de deux transitions de sortie. La mise en vis-à-vis des deux plateaux permet d'évacuer le flux thermique vers l'extérieur. De la même façon, il est possible de regrouper un nombre de modules amplificateurs supérieur à deux, les modules regroupés étant disposés sur des plateaux distincts et superposés les uns au-dessus des autres.

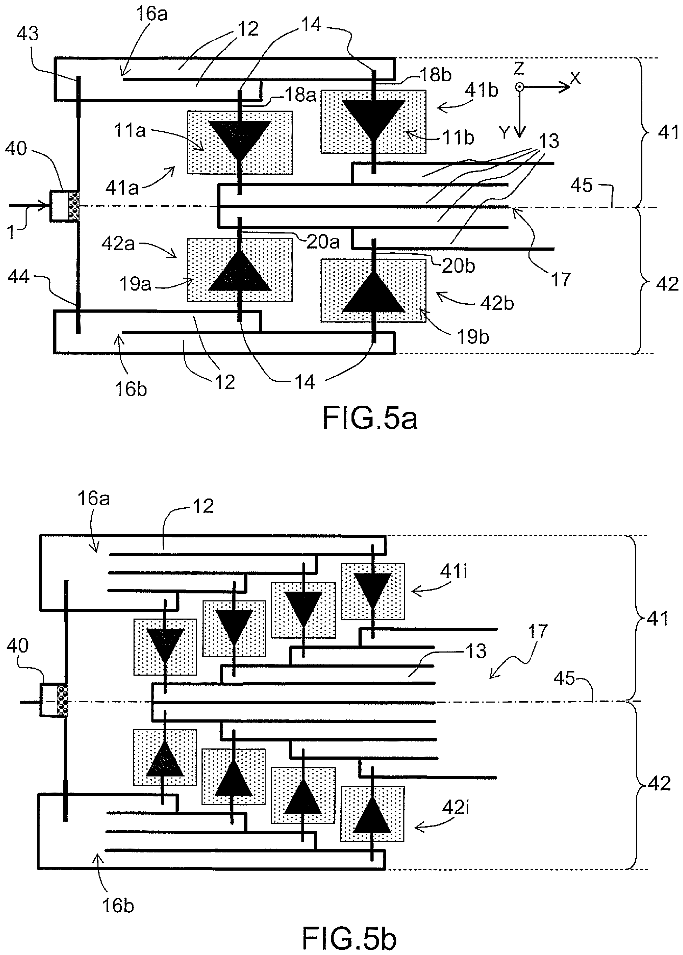

Un troisième exemple représenté schématiquement sur la figure 5a montre un dispositif d'amplification comprenant quatre modules amplificateurs combinés sur un même plateau, selon une deuxième variante de réalisation de l'invention.

Les quatre modules amplificateurs sont combinés deux à deux sur deux rangées d'amplification 41, 42 distinctes parallèles à l'axe de propagation, chaque rangée d'amplification comportant le même nombre de voies amplificatrices, par exemple deux voies comme sur la figure 5a, chaque voie amplificatrice comportant un module amplificateur. Le dispositif d'amplification comporte un premier diviseur de puissance d'entrée 40, de type planaire, dont l'accès s'effectue par une entrée de type micro-ruban et permettant de diviser un signal hyperfréquence d'entrée 1 en deux composantes pour illuminer deux guides d'ondes rectangulaires d'entrée reliés respectivement à l'une des deux rangées d'amplification, à travers deux transitions 43, 44. Alternativement, le diviseur de puissance 40 pourrait être un septum diviseur. Dans chaque rangée d'amplification 41, 42, les deux voies amplificatrices sont précédées par un deuxième diviseur de puissance 16a, 16b comportant deux sorties reliées respectivement à chaque guide d'ondes de connexion d'entrée 12 des modules amplificateurs 41a, 41b, 42a, 42b correspondants. Le deuxième diviseur de puissance 16a, 16b, par exemple de type septum diviser, permet de diviser une deuxième fois la composante du signal hyperfréquence issue de l'une des transitions 43, 44 en deux nouvelles composantes se propageant respectivement dans les deux guides d'ondes de connexion d'entrée 12 des deux voies amplificatrices correspondantes. Les deux modules amplificateurs 41a, 41b des deux voies amplificatrices de la première rangée 41 sont montés symétriquement par rapport aux deux modules amplificateurs 42a, 42b de la deuxième rangée 42, de part et d'autre d'un axe de symétrie 45 parallèle à la direction de propagation X. Chaque module amplificateur 41a, 41b de la première rangée 41 comporte un élément amplificateur 11a, 11b ayant un axe d'entrée et de sortie 18a, 18b orienté suivant la direction Y et aligné respectivement avec un axe d'entrée et de sortie 20a, 20b d'un élément amplificateur 19a, 19b d'un module amplificateur 42a, 42b de la deuxième rangée 42. Les guides d'ondes de connexion de sortie 13 de tous les éléments amplificateurs des deux rangées sont séparés et accolés les uns aux autres, permettant la recombinaison en phase de tous les signaux en sortie du combineur de puissance 17 de sortie commun à tous les guides d'ondes de sortie des deux rangées 41, 42.

Les signaux se propagent dans les guides d'ondes rectangulaires de connexion 12 à partir des transitions de sortie 43, 44 du diviseur d'entrée 40 et après division au travers du deuxième diviseur 16a, 16b de chaque rangée 41, 42 vers des éléments de transitions d'entrées 14 des modules amplificateurs 41a, 41b, 42a, 42b. Après amplification, les signaux se propagent dans les guides d'ondes de connexion de sortie jusqu'au combineur de puissance 17 où ils sont recombinés en phase.

Le nombre de modules amplificateurs dans chaque rangée n'est pas limité à deux. Comme représenté sur la figure 5b qui montre une combinaison de quatre modules amplificateurs 41i, 42i par rangée 41, 42, il est possible de combiner un grand nombre de modules amplificateurs dans chaque rangée.

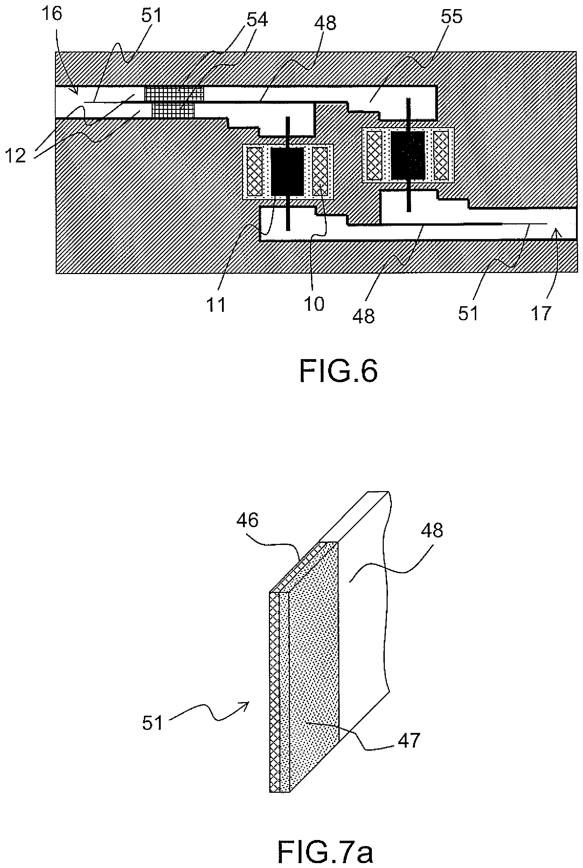

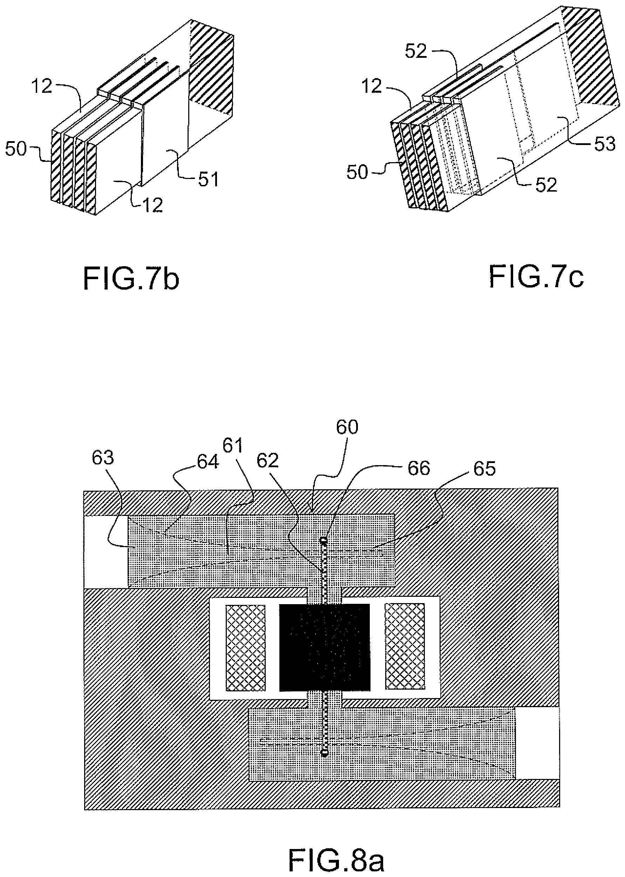

Dans le mode de réalisation représenté sur la figure 6, le dispositif d'amplification comporte des portions de guides d'adaptation 55 placées dans les guides d'ondes de connexion d'entrée et de sortie juste en amont et en aval de chaque élément amplificateur. En outre, le diviseur d'entrée 16 et le combineur 17 comprennent chacun un septum résistif prolongeant, en entrée et en sortie, les parois métalliques 48 séparant les guides d'ondes rectangulaires de connexion. Comme représenté par exemple sur la figure 7a, chaque septum comporte au moins une paroi 51 munie d'une surface résistive qui a pour fonction d'assurer l'isolation entre les modules amplificateurs afin d'améliorer la stabilité électrique du dispositif d'amplification et de simplifier le réglage de sa phase puisqu'il permet de régler chaque module amplificateur séparément des autres modules. La surface résistive peut être constituée d'un film résistif placé en un plan de symétrie entre deux substrats identiques 46, 47, par exemple en céramique telle que l'alumine ou le nitrure d'aluminium. Comme représenté sur la figure 7b, dans le septum à un étage, les surfaces résistives des parois 51 sont toutes montées à une même distance de l'entrée 50 du combineur ou du diviseur.

Alternativement, pour un dispositif d'amplification comportant plus de deux modules amplificateurs dans une même rangée, comme l'exemple représenté sur la figure 3b, il est possible d'utiliser un septum comportant plusieurs étages, par exemple deux étages comme le montre le combineur de la figure 7c, comportant des premières parois 52 munies de films résistifs disposés à une distance prédéterminée de l'entrée 50 du combineur, et d'autres parois 53 munies de films résistifs disposés de façon décalée et en retrait par rapport aux films résistifs des premières parois 52. Un diviseur comportant un septum a une configuration similaire en inversant l'entrée et la sortie par rapport au combineur. Le septum à deux étages du diviseur 16 réalise une division du signal d'entrée en deux étapes successives permettant d'obtenir quatre composantes du signal, chaque composante étant dirigée dans l'un des quatre guides de connexion d'entrée de quatre modules d'amplification : une première division du signal en deux composantes est réalisée grâce à une première paroi 52 du premier étage de septum suivie d'une deuxième division de chacune des composantes en deux autres composantes grâce à deux autres parois 53 du deuxième étage de septum. Dans les guides de sortie 13, le combineur 17 comporte également un septum à deux étages permettant de recombiner les signaux en deux étapes successives grâce aux parois 53, 52 du septum. Le nombre de parois du septum du diviseur et du combineur n'est pas limité à trois comme représenté sur les exemples de réalisation mais peut être adapté en fonction du nombre de composantes de signal souhaitées pour les différentes voies amplificatrices du dispositif d'amplification.

Le réglage de la phase peut être réalisé par des éléments de réglage de phase 54 montés dans chacun des guides de connexion d'entrée 12 pour contrôler la phase relative entre les signaux se propageant dans les guides d'ondes de connexion 12 de manière à assurer une recombinaison en phase de ces signaux dans le guide d'onde de sortie une fois amplifiés par les modules amplificateurs. Cette fonctionnalité permet de minimiser les pertes de combinaison en supprimant les pertes induites par un déséquilibre de phase de signaux combinés dus aux tolérances de fabrication. Les éléments de réglage de phase 54 peuvent être réalisés par exemple par des éléments diélectriques de formes diverses. Alternativement, les éléments de déphasage peuvent être des déphaseurs à lames ou à rondins diélectriques réglables par vis micrométriques. Les profondeurs d'enfoncement de ces éléments diélectriques dans les guides de connexion 12 permettent alors d'agir sur les phases des signaux se propageant dans les guides de connexions 12.

Les transitions d'entrée et/ou de sortie peuvent être réalisées par exemple en utilisant une ligne à ailettes 60 munie d'une fente 61 associée à une ligne micro-ruban 62 comme représenté sur la figure 8a. Le signal se propageant dans le guide d'onde de connexion d'entrée est capté par une antenne Vivaldi 64 formée sur la face inférieure du substrat 63. Les bords de métallisations sur la face inférieure du substrat 63 sont matérialisés par des pointillés. En sortie de l'antenne Vivaldi, un stub $\lambda/4$ en circuit ouvert 65 et un trou métallisé 66 reliant les deux faces métallisés du substrat permet de passer du mode fente au mode micro-ruban se propageant dans la ligne micro-ruban 62.

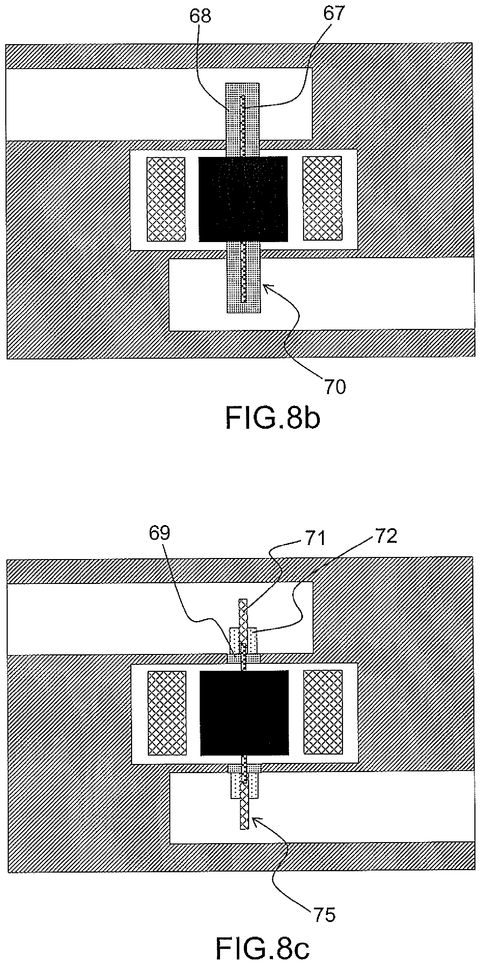

Alternativement, comme représenté sur la figure 8b, les transitions peuvent être réalisées en utilisant un plongeur 70 comportant une ligne de métallisation 67 placée sur un substrat 68 ou, comme représenté sur la figure 8c, en utilisant un plongeur mécanique 75 utilisant une perle de verre 69, un cylindre 71 prolongeant l'âme de la perle de verre et un diélectrique 72 contribuant à l'adaptation de la transition.

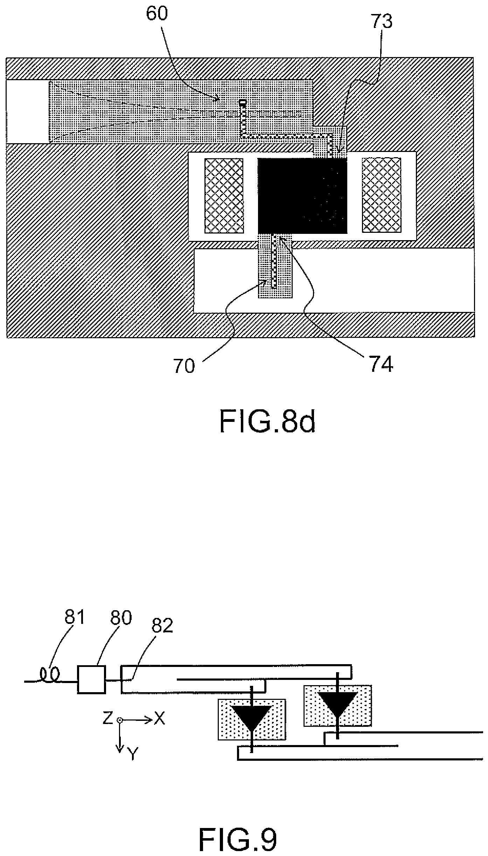

Alternativement, il est possible de combiner, en entrée et en sortie, deux types de transitions différentes. Par exemple, comme représenté sur la figure 8d, il est possible d'utiliser une transition d'entrée comportant une ligne à ailettes 60 et une transition de sortie comportant un plongeur 70 monté sur un substrat. Sur cette figure, l'entrée 73 et la sortie 74 de l'élément amplificateur ne sont pas sur le même axe.

La figure 9 montre un exemple de dispositif d'alimentation pouvant être appliqué en entrée du dispositif d'amplification de puissance à encombrement réduit. Le dispositif d'alimentation comporte un dispositif opto-électronique 80, par exemple de type photodiode ou photodiode avec amplificateur, recevant, par l'intermédiaire d'une fibre optique 81, un signal lumineux modulé par un signal RF à amplifier. Après détection par le dispositif à photodiode, le signal RF est transmis en entrée du diviseur de puissance par l'intermédiaire d'une transition 82.

La solution proposée dans la présente description permet de combiner un grand nombre de modules amplificateurs, par exemple huit amplificateurs, sur une ou plusieurs rangées et sur un ou plusieurs plateaux dans une maille d'antenne de l'ordre de six centimètres avec :

- de très faibles pertes d'insertion du diviseur et du combineur pour ne pas dégrader le rendement en puissance ajoutée du dispositif ;
- une sortie en guide d'ondes rectangulaire pour être directement compatible avec l'interface des circuits placés en aval ;
- une entrée en technologie planaire permettant une meilleure compatibilité avec les circuits placés en amont ;
- un espace suffisant autour des amplificateurs pour pouvoir placer les capacités de découplage nécessaires à la stabilité électrique de l'amplificateur ;
- une très bonne gestion thermique pour respecter les contraintes spatiales sur les températures de jonction des semi-conducteurs ;
- un encombrement réduit pour minimiser le poids de l'équipement ;
- une facilité d'assemblage permettant d'offrir une solution à bas coûts.
- Une compatibilité possible avec des systèmes de transport des signaux RF par fibre optique.

**Revendications**

1. Dispositif d'amplification à encombrement réduit comportant au moins un plateau parallèle à un plan XY et N modules amplificateurs (41a, 41b) montés sur le plateau, où N est supérieur à un, chaque module amplificateur (41a, 41b) comportant par ordre de connexion, un guide d'ondes de connexion d'entrée (12a, 12b), une transition d'entrée (14a, 14b), un élément amplificateur (11a, 11b), une transition de sortie (15a, 15b), et un guide d'ondes de connexion de sortie (13a, 13b), le guide d'ondes de connexion d'entrée (12a, 12b) et le guide d'ondes de connexion de sortie (13a, 13b) étant orientés selon une même direction X correspondant à une direction de propagation longitudinale, l'élément amplificateur (11a, 11b) ayant un axe d'entrée et de sortie (18a, 18b) orienté selon une direction Y perpendiculaire à la direction de propagation X, les guides d'ondes de connexion d'entrée (12a, 12b) et de sortie (13a, 13b) étant à parois métalliques, le dispositif d'amplification comportant en outre un diviseur de puissance (16) d'entrée et un combineur de puissance (17) de sortie en technologie guide d'ondes métallique, le diviseur de puissance (16) et le combineur de puissance (17) comportant chacun au moins un septum résistif (51), et en ce que les septum du diviseur de puissance et du combineur de puissance prolongent respectivement des parois métalliques (48) séparant les N guides d'ondes de connexion d'entrée et de sortie (12a, 12b, 13a, 13b) des éléments amplificateurs (11a, 11b), la somme des longueurs du guide d'ondes d'entrée et du guide d'ondes de sortie de chaque module amplificateur étant identique pour les N modules amplificateurs, le dispositif d'amplification étant **caractérisé en ce que** les éléments amplificateurs (11a, 11b) sont montés parallèlement entre eux sur au moins une rangée (41) et décalés l'un par rapport à l'autre selon les deux directions perpendiculaires X et Y et **en ce que** les guides d'ondes d'entrée (12a, 12b), respectivement les guides d'ondes de sortie (13a, 13b), des éléments amplificateurs (11a, 11b) de la rangée (41) sont accolés les uns aux autres.

2. Dispositif d'amplification selon la revendication 1, **caractérisé en ce que** les guides d'ondes de connexion d'entrée et de sortie (12a, 12b, 13a, 13b) sont des guides d'ondes métalliques à section rectangulaire.

3. Dispositif d'amplification selon l'une des revendications précédentes, **caractérisé en ce qu'**il comporte deux rangées d'amplification (41, 42) distinctes, chaque rangée d'amplification comportant le même nombre de modules amplificateurs (41a, 41b, 42a, 42b), les modules amplificateurs (41a, 41b) de la première rangée (41) étant montés symétriquement par rapport aux modules amplificateurs (42a, 42b) de la deuxième rangée (42), de part et d'autre d'un axe de symétrie (45) parallèle à la direction de propagation.

4. Dispositif d'amplification selon la revendication 3, **caractérisé en ce que** chaque module amplificateur (41a, 41b) de la première rangée (41) comporte un élément amplificateur (11a, 11b) ayant un axe d'entrée et de sortie (18a, 18b) orienté suivant la direction Y et aligné respectivement avec un axe d'entrée et de sortie (20a, 20b) d'un élément amplificateur (19a, 19b) d'un module amplificateur (42a, 42b) de la deuxième rangée (42).

5. Dispositif d'amplification selon la revendication 4, **caractérisé en ce que** les guides d'ondes de connexion de sortie (13) des éléments amplificateurs de tous les modules amplificateurs (41a, 41b, 42a, 42b) des deux rangées (41, 42) sont distincts, accolés les uns aux autres et reliés à un combineur de puissance (17) de sortie, commun à tous les guides d'ondes de connexion de sortie (13).

6. Dispositif d'amplification selon l'une des revendications 3 à 5, **caractérisé en ce qu'**il comporte un premier diviseur de puissance d'entrée (40) ayant deux sorties reliées respectivement aux deux rangées d'amplification (41, 42), à travers deux transitions (43, 44) et **en ce que** chaque rangée d'amplification (41, 42) comporte un deuxième diviseur de puissance (16a, 16b) ayant des sorties reliées respectivement à chaque guide d'ondes de connexion d'entrée (12) des modules amplificateurs (41a, 41b, 42a, 42b) correspondants.

7. Dispositif d'amplification selon la revendication 6, **caractérisé en ce que** le premier diviseur de puissance d'entrée (40) a une entrée de type micro-ruban.

8. Dispositif d'amplification selon l'une des revendications précédentes, **caractérisé en ce qu'**il comporte au moins deux modules amplificateurs (23, 24) superposés l'un au-dessus de l'autre, les deux modules amplificateurs étant disposés sur au moins deux plateaux (21, 22) distincts, superposés l'un au-dessus de l'autre et comportant un même nombre de modules amplificateurs (23, 24) et **en ce que** les deux modules amplificateurs (23, 24) superposés ont un guide d'entrée et un guide de sortie en commun.

9. Dispositif d'amplification selon l'une quelconque des revendications précédentes, **caractérisé en ce que** les éléments de transitions (14a, 14b, 15a, 15b, 43, 44) sont choisis parmi des lignes à ailettes (60), ou des plongeurs (70) comportant une ligne de métallisation (67) placée sur un substrat (68), ou des plongeurs mécaniques (75) utilisant une perle de verre (69).

10. Dispositif d'amplification selon l'une quelconque des revendications précédentes, le diviseur de puissance et le combineur de puissance sont des guides d'ondes métalliques à section rectangulaire.

11. Dispositif d'amplification selon l'une quelconque des revendications précédentes, **caractérisé en ce que** chaque guide d'onde de connexion d'entrée (12) est équipé d'un élément de réglage de phase (54).

12. Dispositif d'amplification selon l'une quelconque des revendications précédentes, **caractérisé en ce qu'**il comporte un dispositif d'alimentation opto-électronique (80) connecté en entrée du dispositif d'amplification par l'intermédiaire d'une fibre optique (81) et d'une transition (82).

**Patentansprüche**

1. Verstärkungsvorrichtung mit reduzierter Masse, die wenigstens eine Platte parallel zu einer XY-Ebene und N an der Platte montierte Verstärkermodule (41a, 41b) umfasst, wobei N größer ist als eins, wobei jedes Verstärkermodul (41a, 41b) in Verbindungsreihenfolge einen Eingangsverbindungswellenleiter (12a, 12b), einen Eingangsübergang (14a, 14b), ein Verstärkerelement (11a, 11b), einen Ausgangsübergang (15a, 15b) und einen Ausgangsverbindungswellenleiter (13a, 13b) umfasst, wobei der Eingangsverbindungswellenleiter (12a, 12b) und der Ausgangsverbindungswellenleiter (13a, 13b) in einer selben Richtung X entsprechend einer Längsausbreitungsrichtung orientiert sind, wobei das Verstärkerelement (11a, 11b) eine Ein- und eine Ausgangsachse (18a, 18b) hat, orientiert in einer Richtung Y lotrecht zur Ausbreitungsrichtung X, wobei die Eingangs- (12a, 12b) und die Ausgangs- (13a, 13b) Verbindungswellenleiter metallische Wände haben, wobei die Verstärkungsvorrichtung ferner einen Eingangsleistungsteiler (16) und einen Ausgangsleistungskombinator (17) in metallischer Wellenleitertechnologie haben, wobei der Leistungteiler (16) und der Leistungskombinator (17) jeweils wenigstens eine resistive Scheidewand (51) umfassen, und dadurch, dass die Scheidewände des Leistungsverteilers und des Leistungskombinators jeweils die metallischen Wände (48) verlängern, die die N Eingangs- und Ausgangs- (12a, 12b, 13a, 13b) Verbindungswellenleiter der Verstärkungselemente (11a, 11b) trennen, wobei die Summe der Längen des Eingangswellenleiters und des Ausgangswellenleiters jedes Verstärkermoduls für die N Verstärkermodule identisch sind, wobei die Verstärkungsvorrichtung **dadurch gekennzeichnet ist, dass** die Verstärkungselemente (11a, 11b) parallel zueinander auf wenigstens einer Reihe (41) montiert und gemäß den beiden lotrechten Richtungen X und Y voneinander versetzt sind, und dadurch, dass die Eingangswellenleiter (12a, 12b) bzw. die Ausgangswellenleiter (13a, 13b) der Verstärkerelemente (11a, 11b) der Reihe (41) aneinander gefügt sind.

2. Verstärkungsvorrichtung nach Anspruch 1, **dadurch gekennzeichnet, dass** die Eingangs- und Ausgangsverbindungswellenleiter (12a, 12b, 13a, 13b) metallische Wellenleiter mit rechteckigem Querschnitt sind.

**3.** Verstärkungsvorrichtung nach einem der vorherigen Ansprüche, **dadurch gekennzeichnet, dass** sie zwei separate Verstärkungsreihen (41, 42) umfasst, wobei jede Verstärkungsreihe dieselbe Anzahl an Verstärkungsmodulen (41a, 41b, 42a, 42b) umfasst, wobei die Verstärkungsmodule (41a, 41b) der ersten Reihe (41) symmetrisch in Bezug auf die Verstärkungsmodule (42a, 42b) der zweiten Reihe (42) auf beiden Seiten einer Symmetrieachse (45) parallel zur Ausbreitungsrichtung montiert sind.

**4.** Verstärkungsvorrichtung nach Anspruch 3, **dadurch gekennzeichnet, dass** jedes Verstärkungsmodul (41a, 41b) derselben Reihe (41) ein Verstärkungselement (11a, 11b) mit einer Eingangs- und Ausgangsachse (18a, 18b) umfasst, orientiert in Richtung Y und jeweils ausgerichtet mit einer Eingangs- und Ausgangsachse (20a, 20b) eines Verstärkungselements (19a, 19b) eines Verstärkungsmoduls (42a, 42b) der zweiten Reihe (42).

**5.** Verstärkungsvorrichtung nach Anspruch 4, **dadurch gekennzeichnet, dass** die Ausgangsverbindungswellenleiter (13) der Verstärkungselemente aller Verstärkungsmodule (41a, 41b, 42a, 42b) der zwei Reihen (41, 42) separat sind, aneinander angefügt und mit einem Ausgangsleistungskombinator (17) verbunden sind, der allen Ausgangsverbindungswellenleitern (13) gemeinsam ist.

**6.** Verstärkungsvorrichtung nach einem der Ansprüche 3 bis 5, **dadurch gekennzeichnet, dass** sie einen ersten Eingangsleistungsteiler (40) mit zwei Ausgängen umfasst, die jeweils mit den zwei Verstärkungsreihen (41, 42) durch zwei Übergänge (43, 44) verbunden sind, und dadurch, dass jede Verstärkungsreihe (41, 42) einen zweiten Leistungsteiler (16a, 16b) mit Ausgängen umfasst, die jeweils mit jedem Eingangsverbindungswellenleiter (12) der entsprechenden Verstärkungsmodule (41a, 41b, 42a, 42b) verbunden sind.

**7.** Verstärkungsvorrichtung nach Anspruch 6, **dadurch gekennzeichnet, dass** der erste Eingangsleistungsteiler (40) einen Eingang des Mikrostreifentyps hat.

**8.** Verstärkungsvorrichtung nach einem der vorherigen Ansprüche, **dadurch gekennzeichnet, dass** sie wenigstens zwei übereinander gelagerte Verstärkermodule (23, 24) umfasst, wobei die zwei Verstärkermodule auf wenigstens zwei separaten Platten (21, 22) angeordnet sind, die übereinander gelagert sind und eine selbe Anzahl von Verstärkermodulen (23, 24) umfassen, und dadurch, dass die übereinander gelagerten Verstärkermodule (23, 24) einen gemeinsamen Eingangsleiter und einen gemeinsamen Ausgangsleiter haben.

**9.** Verstärkungsvorrichtung nach einem der vorherigen Ansprüche, **dadurch gekennzeichnet, dass** die Übergangselemente (14a, 14b, 15a, 15b, 43, 44) ausgewählt sind aus gerippten Leitungen (60) oder Stößeln (70), umfassend eine auf einem Substrat (68) platzierte Metallisierungsleitung (67), oder mechanischen Stößeln (75), die eine Glasperle (69) verwenden.

**10.** Verstärkungsvorrichtung nach einem der vorherigen Ansprüche, wobei der Leistungsteiler und der Leistungskombinator metallische Wellenleiter mit rechteckigem Querschnitt sind.

**11.** Verstärkungsvorrichtung nach einem der vorherigen Ansprüche, **dadurch gekennzeichnet, dass** jeder Eingangsverbindungswellenleiter (12) mit einem Phasenregelungselement (54) ausgestattet ist.

**12.** Verstärkungsvorrichtung nach einem der vorherigen Ansprüche, **dadurch gekennzeichnet, dass** sie eine optoelektronische Speisevorrichtung (80) umfasst, die am Eingang der Verstärkungsvorrichtung durch einen Lichtwellenleiter (81) und einen Übergang (82) verbunden ist.

**Claims**

**1.** An amplification device with reduced bulk comprising at least one plate parallel to a plane XY and N amplifier modules (41a, 41b) mounted on the plate, where N is greater than 1, each amplifier module (41a, 41b) comprising, in order of connection, an input connection waveguide (12a, 12b), an input transition (14a, 14b), an amplifier element (11a, 11b), an output transition (15a, 15b), and an output connection waveguide (13a, 13b), the input connection waveguide (12a, 12b) and the output connection waveguide (13a, 13b) being oriented in one and the same direction X corresponding to a direction of longitudinal propagation, the amplifier element (11a, 11b) having an input and output axis (18a, 18b) oriented in a direction Y perpendicular to the direction of propagation X, the input (12a, 12b) and the output (13a, 13b) connection waveguides having metallic walls, the amplification device further comprising an input power divider (16) and an output power combiner (17) with metallic waveguide technology, the power divider (16) and the power combiner (17) each comprising at least one resistive septum (51), and in that the septum of the power divider and the septum of the power combiner extend respectively the metallic walls (48) separating the N input and output connection waveguides (12a, 12b, 13a, 13b) of the amplifier elements (11a, 11b), the sum of the lengths of the input waveguide and of the output waveguide of each amplifier module being identical for the N amplifier modules, the amplification device being **characterised in that** the amplifier elements (11a, 11b) are mounted in parallel in at least one row (41) and offset with respect to one another in the two perpendicular directions X and Y and **in that** the input waveguides (12a, 12b), respectively the output waveguides (13a, 13b), of the amplifier elements (11a, 11b) of the row (41) adjoin one another.

2. The amplification device according to Claim 1, **characterised in that** the input and output connection waveguides (12a, 12b, 13a, 13b) are metallic waveguides with a rectangular cross-section.

3. The amplification device according to either of the preceding claims, **characterised in that** it comprises two distinct amplification rows (41, 42), each amplification row comprising the same number of amplifier modules (41a, 41b, 42a, 42b), the amplifier modules (41a, 41b) of the first row (41) being mounted symmetrically with respect to the amplifier modules (42a, 42b) of the second row (42), on either side of an axis of symmetry (45) parallel to the direction of propagation.

4. The amplification device according to Claim 3, **characterised in that** each amplifier module (41a, 41b) of the first row (41) comprises an amplifier element (11a, 11b) having an input and output axis (18a, 18b) oriented along the direction Y and aligned respectively with an input and output axis (20a, 20b) of an amplifier element (19a, 19b) of an amplifier module (42a, 42b) of the second row (42).

5. The amplification device according to Claim 4, **characterised in that** the output connection waveguides (13) of the amplifier elements of all the amplifier modules (41a, 41b, 42a, 42b) of the two rows (41, 42) are distinct, adjoining one another and linked to an output power combiner (17), common to all the output connection waveguides (13).

6. The amplification device according to any of Claims 3 to 5, **characterised in that** it comprises a first input power divider (40) having two outputs linked respectively to the two amplification rows (41, 42), across two transitions (43, 44) and **in that** each amplification row (41, 42) comprises a second power divider (16a, 16b) having outputs linked respectively to each input connection waveguide (12) of the corresponding amplifier modules (41a, 41b, 42a, 42b).

7. The amplification device according to Claim 6, **characterised in that** the first input power divider (40) has an input of the microstrip type.

8. The amplification device according to any of the preceding claims, **characterised in that** it comprises at least two amplifier modules (23, 24) overlaid one above the other, the two amplifier modules being disposed on at least two distinct plates (21, 22), overlaid one above the other and comprising a same number of amplifier modules (23, 24) and **in that** the two overlaid amplifier modules (23, 24) have an input guide and an output guide in common.

9. The amplification device according to any one of the preceding claims, **characterised in that** the transition elements (14a, 14b, 15a, 15b, 43, 44) are chosen from fin lines (60), or plungers (70) comprising a metallisation line (67) placed on a substrate (68), or mechanical plungers (75) using a glass bead (69).

10. The amplification device according to any one of the preceding claims, the power divider and the power combiner being metallic waveguides with rectangular cross-section.

11. The amplification device according to any one of the preceding claims, **characterised in that** each input connection waveguide (12) is equipped with a phase adjustment element (54).

12. The amplification device according to any one of the preceding claims, **characterised in that** it comprises an opto-electronic feed device (80) connected at the input of the amplification device by means of an optical fibre (81) and a transition (82).

**FIG.1**

**FIG.2**

**FIG.3a**

FIG.3b

FIG.3c

Coupe I-I

FIG.3d

Coupe J-J

FIG.3e

Coupe I-I

FIG.4a

Coupe J-J

FIG.4b

FIG.5a

FIG.5b

FIG.6

FIG.7a

FIG.7b

FIG.7c

FIG.8a

68    67

FIG.8b

70

69    71    72

75

FIG.8c

FIG.8d

FIG.9

**EP 2 422 401 B1**

**RÉFÉRENCES CITÉES DANS LA DESCRIPTION**

**Documents brevets cités dans la description**

- US 5736908 A
- WO 20060967771 A
- EP 0032332 A
- WO 2009026704 A